# EUROPÄISCHE PATENTSCHRIFT

(11) **EP 0 582 125 B1**
(45) Veröffentlichungstag und Bekanntmachung des Hinweises auf die Patenterteilung: **28.01.1998**
(21) Anmeldenummer: 93111602.4
(22) Anmeldetag: 20.07.1993
(51) Int. Cl.: H03K 17/687, H03K 17/06, H01L 27/088

(54) **Ansteuerschaltung für einen Leistungs-MOSFET mit sourceseitiger Last**
Control circuit for a power MOSFET having a load connected to the source
Circuit de commande pour un MOSFET de puissance ayant une charge connectée à la source

(30) Priorität: 04.08.1992 DE 4225754
(43) Veröffentlichungstag der Anmeldung: 09.02.1994
(73) Patentinhaber: SIEMENS AKTIENGESELLSCHAFT, 80333 München (DE)
(72) Erfinder: Leipold, Ludwig, Dipl.-Ing., D-80809 München (DE); Sander, Rainald, Dipl.-Phys., D-81379 München (DE); Tihanyi, Jenö, Dr.-Ing., D-80689 München (DE)

(56) Entgegenhaltungen:
- EP-A- 0 236 967
- EP-A- 0 240 436
- US-A- 4 603 269
- IEEE TRANSACTIONS ON ELECTRON DEVICES Bd. 37, Nr. 4, April 1990, Seiten 1154 - 1161 A. ELMOZNINE ET AL.: 'The smart power high-side switch: Description of a specific technology, its basic devices, and monitoring circuitries'
- SIEMENS FORSCH.- U. ENTWICKL. - BER. Bd. 17, Nr. 1, 1988, Seiten 35 - 42 J. TIHANYI: 'Smart SIPMOS Technology'
- PATENT ABSTRACTS OF JAPAN vol. 008, no. 213 (E-269)28. September 1984

## Beschreibung

Die Erfindung bezieht sich auf eine Ansteuerschaltung für einen Leistungs-MOSFET mit sourceseitiger Last, mit zwei hintereinander geschalteten Dioden, mit deren Verbindungspunkt ein erster Anschluß eines Kondensators verbunden ist, an dessen zweiten Anschluß eine oszillierende Spannung angelegt ist und bei der die zweite Diode mit dem Gateanschluß des Leistungs-MOSFET verbunden ist, wobei die zweite Diode ein als Diode geschalteter Depletion-FET ist.

Eine solche Ansteuerschaltung ist z. B. im Europäischen Patent 0 236 967 beschrieben worden. Bei einer integrierten Anordnung dieser Art können die erwähnten Dioden wegen parasitärer Transistoreffekte nicht in selbstisolierender Technik hergestellt werden, wenn Sperrspannungen größer als 0,5...0,7 Volt bereitgestellt werden müssen. Die den Dioden eigene Durchlaßspannung von 0,5...0,7 Volt führt außerdem zu Verlusten, die dann nicht mehr zu vernachlässigen sind, wenn die Betriebsspannung z. B. nur 5 Volt beträgt.

Ziel der Erfindung ist, eine Ansteuerschaltung der beschriebenen Art so weiterzubilden, daß sie in selbstisolierender Technik herstellbar ist und die Verluste im Pumpbetrieb herabgesetzt werden können.

Dieses Ziel wird dadurch erreicht, daß der Depletion-FET einen Substratanschluß hat, der mit dem zweiten Anschluß des Kondensators verbunden ist.

Weiterbildung der Erfindung sind Gegenstand der Unteransprüche.

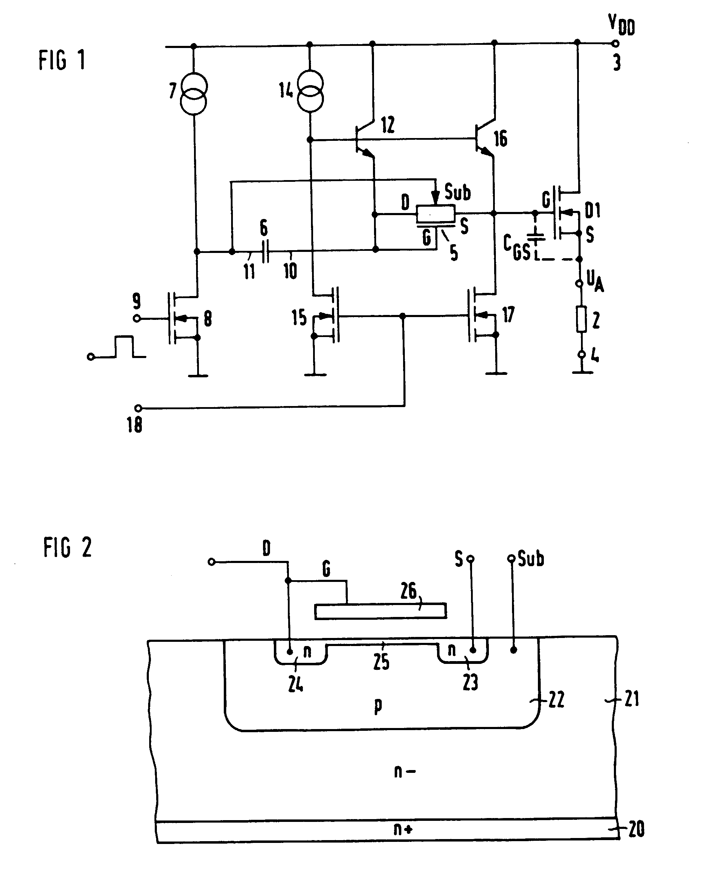

Die Erfindung wird anhand eines Ausführungsbeispiels in Verbindung mit den Figuren 1 und 2 näher erläutert. Es zeigen:
Figur 1 den Schaltungsaufbau gemäß Erfindung und
Figur 2 einen Schnitt durch den Depletion-Fet in selbstisolierender Technik mit einem Substratanschluß.

Die Ansteuerschaltung nach Figur 1 enthält einen Leistungs-FET 1, dem sourceseitig eine Last 2 in Reihe geschaltet ist. Die Reihenschaltung liegt über zwei Anschlüsse 3, 4 an einer Betriebsspannung V_{DD}. Dabei ist der Drainanschluß D des Leistungs-FET mit dem Anschluß 3 verbunden. Mit dem Gateanschluß G von 1 ist der Sourceanschluß S eines als Diode geschalteten Depletion-FET 5 verbunden. Der Depletion-FET 5 ist vom gleichen Leitungstyp wie der Leistungs-FET 1. Der Drainanschluß D des Depletion-FET 5 ist mit einem ersten Anschluß 10 eines Kondensators 6 verbunden, sein zweiter Anschluß 11 kann über einen steuerbaren Schalter 8 an Masse gelegt werden. Der zweite Anschluß 11 des Kondensators 6 ist über eine Stromquelle 7 an V_{DD} gelegt. weiter ist der Drainanschluß des Depletion-FET 5 über die Emitter-Kollektorstrecke eines ersten Bipolartransistors 12 mit V_{DD} verbunden. Sein Basisanschluß ist mit dem Knoten einer Reihenschaltung verbunden, die aus einer Stromquelle 14 und einem zweiten steuerbaren Schalter 15 besteht. Die Stromquelle 14 ist dabei zwischen dem Basisanschluß des Bipolartransistors 12 und dem Anschluß 3 angeschlossen. Weiterhin ist zwischen dem Anschluß 3 und Masse die Reihenschaltung aus einem zweiten Bipolartransistor 16 und einem dritten steuerbaren Schalter 17 angeschlossen. Der Knoten dieser Reihenschaltung ist mit dem Gateanschluß G des Leistungs-FET 1 verbunden. Der zweite und dritte steuerbare Schalter 15 bzw. 17 sind hier als Feldeffekttransistoren ausgeführt, deren Gateananschlüsse mit einem Eingangsanschluß 18 verbunden sind.

Zur Erläuterung der Wirkungsweise sei angenommen, daß der Leistungs-FET 1 zunächst gesperrt ist; die steuerbaren Schalter 15 und 17 befinden sich durch eine positive Spannung am Eingangsanschluß 18 in leitendem Zustand. Werden sie gesperrt, so erhalten die Bipolartransistoren 16 über die Stromquelle 14 Steuerstrom und werden leitend. Damit kann die Gate-Source-Kapazität C_{GS} des Leistungs-FET 1 aufgeladen werden und er beginnt zu leiten. Damit steigt die Ausgangsspannung U_{A} am Sourceanschluß des Leistungs-FET 1 an und seine Gatespannung muß weiter erhöht werden, um den Leistungs-FET 1 voll leitend zu steuern.

An den Eingang 9 des steuerbaren Schalter 8 wird nun eine Spannung angelegt, die z. B. zwischen 0 und 5 Volt oszillieren kann. Bei leitendem Schalter 8 fließt ein Strom durch den ersten Bipolartransistor 12 und lädt den Kondensator 6 auf. An seinem zweiten Anschluß 11 liegt immer dann Massepotential, wenn der steuerbare Schalter 8 leitend gesteuert ist. Wird er gesperrt, liegt am zweiten Anschluß 11 über die Stromquelle 7 im wesentlichen das Potential V_{DD} an. Ist die Spannung am Kondensator 6 groß genug, so fließt ein Strom durch den Depletion-FET 5 in die Gate-Source-Kapazität C_{GS} des Leistungs-FET 1. Da das Potential am zweiten Anschluß 11 des Kondensators im wesentlichen zwichen 0 und V_{DD} oszilliert, oszilliert die Spannung am ersten Anschluß 10 des Kondensators 6 im wesentlichen zwischen V_{DD} und 2V_{DD}. Eine Entladung des Kondensators 6 wird durch die Basis-Emitter-Emitterstrecke des Bipolartransistors 12 verhindert, die die eingangs erwähnte zweite Diode bildet.

Der Depletion-FET 5 weist eine Substratsteuerung auf, derart, daß sein Substratanschluß Sub mit dem zweiten Anschluß 11 des Kondensators 6 verbunden ist. D.h., daß die Spannung am Substratanschluß ebenfalls zwischen dem Wert 0 und V_{DD} oszilliert. Mit dieser Substratsteuerung wird eine Änderung der Einsatzspannung des Depletion-FET 5 entsprechend der Frequenz am Eingang erzielt. Liegt das Substrat auf Potential Null Volt, so wird die I_{DS}/U_{DS}-Kennlinie in Richtung höherer I_{D}-Werte verschoben und die Einsatzspannung des Depletion-FET 5 liegt auf einem ersten, höheren Wert. Liegt das Substrat auf dem Potential VDD, so wird die I_{DS}/U_{DS}-Kennlinie in Richtung niedrigerer I_{D}-Werte verschoben und die Einsatzspannung liegt bei einem kleineren Wert. Dies heißt wiederum, daß bei Substratvorspannung V_{DD} schon bei geringer Drain-Sourcespannung viel Strom fließen kann. Dies ist gleichbedeutend mit einer steilen Durchlaßkennlinie der durch den Depletion-FET 5 gebildeten Diode. Liegt das Substrat dagegen auf Null Volt, so sperrt die Diode, sowie die Sourcespannung größer als die Drainspannung wird.

In Figur 2 ist dargestellt, wie der Depletion-FET 5 in selbstisolierender Technik aufgebaut ist. Er ist auf einer stark n-leitenden Halbleiterschicht 20 integriert, an die eine schwächer n-dotierte dicke Schicht 21 angrenzt. In die Schicht 21 ist eine p-dotierte Wanne 22 eingebettet, in die wiederum eine n-leitende Sourcezone 23 und eine n-leitende Drainzone 24 eingebettet sind. Sourcezone 23 und Drainzone 24 sind durch einen n-leitenden Kanal 25 miteinander verbunden. Der Depletion-FET wird durch eine Gateelektrode 26 gesteuert, die im wesentlichen über den Kanal 25 angeordnet ist. Der Drainanschluß D ist mit dem Gateanschluß G verbunden. Die Sourcezone 23 hat einen Sourceanschluß S. Die p-dotierte Wanne 22 hat den Substratanschluß Sub. Durch die über den Substratanschluß an die Wanne 22 gelegte Spannung kann die Einsatzspannung des Depletion-FET unabhängig von der Gatespannung eingestellt werden.

Die Erfindung ist mit geringfügiger Modifikation auch für den Fall einsetzbar, daß der zweite Anschluß 11 des Kondensators direkt mit dem Ausgang einer oszillierenden Spannungsquelle verbunden ist. Hierbei würde die Stromquelle 7 und der steuerbare Schalter 8 wegfallen.

## Patentansprüche

1. Steuerschaltung für einen Leistungs-MOSFET mit sourceseitiger Last, mit einer Pumpschaltung mit zwei hintereinander geschalteten Dioden, mit deren Verbindungspunkt ein erster Anschluß (10) eines Kondensators (6) verbunden ist, an dessen zweiten Anschluß (11) eine oszillierende Spannung angelegt ist und bei der die zweite Diode mit dem Gateanschluß (G) des Leistungs-MOSFET (1) verbunden ist, wobei die zweite Diode ein als Diode geschalteter Depletion-FET (5) ist,
**dadurch gekennzeichnet,**
daß der Depletion-FET einen Substratanschluß (Sub) hat, der mit dem zweiten Anschluß (11) des Kondensators (6) verbunden ist.

2. Ansteuerschaltung nach Anspruch 1,
**dadurch gekennzeichnet,** daß der zweite Anschluß (11) des Kondensators (6) an den Knoten einer ersten Reihenschaltung angeschlossen ist, die aus einer ersten Stromquelle (7) und einen ersten steuerbaren Schalter (8) besteht, und daß die erste Stromquelle an den Drainanschluß des Leistungs-MOSFET (1) und der erste steuerbare Schalter an Masse angeschlossen ist.

3. Ansteuerschaltung nach Anspruch 2,
**dadurch gekennzeichnet,** daß die erste Diode die Basis-Emitter-Strecke eines ersten Bipolartransistors (12) ist, daß der Basisanschluß des ersten Bipolartransistors mit dem Knoten einer zweiten Reihenschaltung verbunden ist, die aus einer zweiten Stromquelle (14) und einem zweiten steuerbaren Schalter (15) besteht, und daß die zweite Stromquelle an den Drainanschluß des Leistungs-MOSFET und der zweite steuerbare Schalter an Masse angeschlossen ist.

4. Ansteuerschaltung nach einem der Ansprüche 1 bis 3,
**gekennzeichnet durch** die Reihenschaltung eines zweiten Bipolartransistors (16) mit einem dritten steuerbaren Schalter (17), deren Knoten mit dem Gateanschluß des Leistungs-MOSFET verbunden ist und durch eine Verbindung der Basisanschlüsse von erstem und zweitem Bipolartransistor.

5. Ansteuerschaltung nach einem der Ansprüche 1 bis 4,
**dadurch gekennzeichnet,** daß der zweite und dritte steuerbare Schalter MOSFET sind, daß die Gateanschlüsse dieser MOSFET miteinander verbunden sind und an einer Steuerspannung angeschlossen werden.

## Claims

1. Control circuit for a power MOSFET having a load connected to the source, having a pump circuit having two series-connected diodes, to the junction point of which a first terminal (10) of a capacitor (6) is connected, an oscillating voltage being applied to the second terminal (11) of the said capacitor, and in which the second diode is connected to the gate terminal (G) of the power MOSFET (1), the second diode being a depletion-mode FET (5) connected as a diode, characterized in that the depletion-mode FET has a substrate terminal (Sub), which is connected to the second terminal (11) of the capacitor (6).

2. Control circuit according to Claim 1, characterized in that the second terminal (11) of the capacitor (6) is connected to the node of a first series circuit comprising a first current source (7) and a first controllable switch (8), and in that the first current source is connected to the drain terminal of the power MOSFET (1) and the first controllable switch is connected to earth.

3. Control circuit according to Claim 2, characterized in that the first diode is the base-emitter junction of a first bipolar transistor (12), in that the base terminal of the first bipolar transistor is connected to the node of a second series circuit comprising a second current source (14) and a second controllable switch (15), and in that the second current source is connected to the drain terminal of the power MOSFET and the second controllable switch is connected to earth.

4. Control circuit according to one of Claims 1 to 3, characterized by the series circuit formed by a second bipolar transistor (16) and a third controllable switch (17), the node of which series circuit is connected to the gate terminal of the power MOSFET, and by a connection of the base terminals of the first and second bipolar transistors.

5. Control circuit according to one of Claims 1 to 4, characterized in that the second and third controllable switches are MOSFETs, in that the gate terminals of these MOSFETs are connected to one another and are connected to a control voltage.

## Revendications

1. Circuit de commande pour un transistor de puissance à effet de champ à grille isolée par oxyde métallique (MOSFET), avec une charge du côté source, avec un circuit de pompage à deux diodes montées l'une derrière l'autre, dont le point commun est relié à une première borne (10) d'un condensateur (6), une tension oscillante étant appliquée à la deuxième borne (11) de ce dernier, la deuxième diode étant reliée à la grille (G) du transistor de puissance (1) à effet de champ à grille isolée par oxyde métallique (MOSFET), cette deuxième diode étant un transistor (5) à effet de champ à déplétion, monté en tant que diode,
**caractérisé**
par le fait que le transistor à effet de champ à déplétion a une borne de substrat (Sub) qui est reliée à la deuxième borne (11) du condensateur (6).

2. Circuit de commande selon la revendication 1
**caractérisé**
par le fait que la deuxième borne (11) du condensateur (6) est reliée au noeud d'un premier circuit série constitué d'une première source de courant (7) et d'une première bascule asservie (8) et
par le fait que la première source de courant est reliée à la borne de drain du transistor de puissance (1) à effet de champ à grille isolée par oxyde métallique (MOSFET) et la première bascule asservie, à la masse.

3. Circuit de commande selon la revendication 2
**caractérisé**
par le fait que la première diode est la ligne base-émetteur d'un premier transistor bipolaire (12),
par le fait que la borne de base du premier transistor bipolaire est reliée au noeud d'un deuxième circuit série constitué d'une deuxième source de courant (14) et d'une deuxième bascule asservie (15) et
par le fait que la deuxième source de courant est raccordée à la borne de drain du transistor de puissance à effet de champ à grille isolée par oxyde métallique (MOSFET) et la deuxième bascule asservie, à la masse.

4. Circuit de commande selon une des revendications 1 à 3,
**caractérisé**
par le circuit série formé d'un deuxième transistor bipolaire (16) et d'une troisième bascule asservie (17), dont le point milieu est relié à la borne de grille du transistor de puissance à effet de champ à grille isolée par oxyde métallique (MOSFET) et par une liaison entre les bornes de base du premier et du deuxième transistor bipolaire.

5. Circuit de commande selon une des revendications 1 à 4
**caractérisé**
par le fait que la deuxième et la troisième bascule sont des transistors à effet de champ à grille isolée par oxyde métallique (MOSFET),
par le fait que les bornes de grille de ces transistors à effet de champ à grille isolée par oxyde métallique (MOSFET) sont reliées l'une à l'autre et qu'elles sont raccordées à une tension de commande.
